# EUROPÄISCHE PATENTANMELDUNG

(11) **EP 2 180 515 A2**
(43) Veröffentlichungstag der Anmeldung: **28.04.2010**
(21) Anmeldenummer: 09013235.8
(22) Anmeldetag: 20.10.2009
(51) Int. Cl.: H01L 27/146

(54) **Bildsensor**

(30) Priorität: 23.10.2008 DE 102008052916
(71) Anmelder: Arnold & Richter Cine Technik GmbH & Co. Betriebs KG, 80799 München (DE)
(72) Erfinder: Cieslinski, Michael, 85521 Ottobrunn (DE)
(74) Vertreter: Manitz, Finsterwald & Partner GbR

(57) **Zusammenfassung**

Die Erfindung betriff einen Bildsensor, insbesondere einen CMOS-Bildsensor, für elektronische Kameras, mit einer Vielzahl von in Zeilen und Spalten angeordneten lichtempfindlichen Pixeln, wobei die Pixel einer jeweiligen Spalte in eine erste Pixelgruppe und eine zweite Pixelgruppe unterteilt sind, wobei in jeder Spalte die Pixel der jeweiligen ersten Pixelgruppe über eine gemeinsame erste Spaltenleitung mit einem gemeinsamen ersten Spaltenverstärker und die Pixel der jeweiligen zweiten Pixelgruppe über eine gemeinsame zweite Spaltenleitung mit einem gemeinsamen zweiten Spaltenverstärker gekoppelt sind. Die Unterteilung der Pixel in die erste Pixelgruppe und die zweite Pixelgruppe ist für unterschiedliche Spalten verschieden.

## Beschreibung

Die vorliegende Erfindung betrifft einen Bildsensor, insbesondere einen CMOS-Bildsensor, für elektronische Kameras, mit einer Vielzahl von in Zeilen und Spalten angeordneten lichtempfindlichen Pixeln.

Bekannte elektronische Kameras enthalten einen Bildsensor, der eine Vielzahl von in Zeilen und Spalten angeordneten lichtempfindlichen Elementen - so genannte Pixel - umfasst, welche durch ein Objektiv der Kamera fallendes Licht in elektrische Signale umwandeln. Zum Auslesen eines Bildes wird jedes der Pixel adressiert, wobei ein jedes Pixel einem jeweiligen Bildpunkt des Bildes entspricht. Ein Signal, das zu einer durch eine Belichtung gesammelten Ladung des Pixels proportional ist, wird zu einem Ausgang des Bildsensors geleitet.

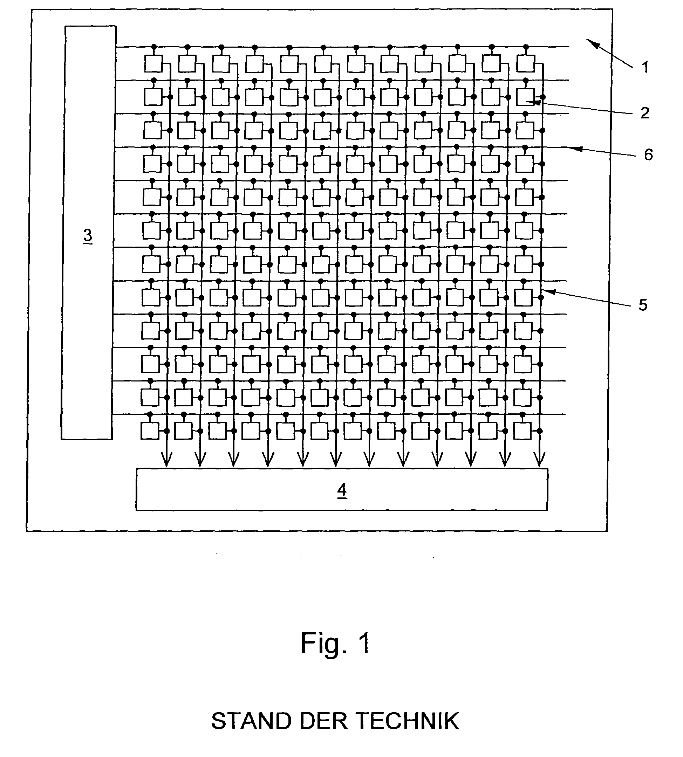

Insbesondere sind Sensoren bekannt, die für jede Zeile eine eigene Zeilenauswahlleitung und für jede Spalte eine eigene Spaltenleitung aufweisen. Ein solcher Bildsensor ist in Fig. 1 dargestellt. Das Auslesen des in Fig. 1 dargestellten Bildsensors 1 erfolgt zeilenweise, d.h. Zeile für Zeile. Hierzu werden mittels der jeweiligen Zeilenauswahlleitung 6 die Pixel 2 der jeweiligen Zeile auf die Spaltenleitungen 5 geschaltet. Jeder der Spaltenleitungen 5 ist ein eigener Spaltenverstärker 4 zugeordnet, um die an den Spaltenleitungen 5 anliegenden Signale der Pixel 2 der ausgewählten Zeile zu verstärken. In Fig. 1 sind die Spaltenverstärker 4 nicht einzeln, sondern in Form eines zusammenhängenden Blocks dargestellt, der die in Reihe angeordneten Spaltenverstärker 4 symbolisiert. Die verstärkten Signale werden dann über eine Multiplexereinrichtung zu dem Ausgang oder, falls mehrere Ausgänge vorgesehen sind, wie es zur Erreichung einer hohen Bildrate bevorzugt ist, den Ausgängen des Bildsensors geführt. Darüber hinaus ist eine Zeilen-Adressierlogik 3 erkennbar, um die der jeweils auszulesenden Zeile zugeordnete Zeilenauswahlleitung 6 zu adressieren.

Die Geschwindigkeit, mit der ein Bild aus dem Bildsensor gemäß Fig. 1 ausgelesen werden kann, wird unter anderem durch diejenige Zeit bestimmt, die das Signal eines Pixels braucht, um von dem Ausgang des Pixels entlang der betreffenden Spaltenleitung zu dem jeweiligen Spaltenverstärker zu gelangen.

Bei Bildsensoren mit großem Bildformat von beispielsweise 20 mm Bildhöhe sind die Spaltenleitungen des Bildsensors ca. 20 mm lang und besitzen eine Kapazität von beispielsweise 10 pF. Typischerweise sind die Pixel nur wenige µm groß. Für jedes Pixel steht also nur wenig Platz zur Verfügung. Da das lichtempfindliche Element eines Pixels möglichst groß sein soll, um eine hohe Lichtempfindlichkeit zu erreichen, müssen die übrigen Elemente eines Pixels umso kleiner gestaltet sein, d.h. es müssen kleine Transistoren verwendet werden. Derartige Transistoren benötigen beispielsweise 2 µs, um die Kapazität einer Spaltenleitung zu treiben. Bei korrelierter Doppelabtastung (correlated double sampling) finden pro auszulesendem Bildpunkt zwei Auslesevorgänge statt, da zur Unterdrückung des thermischen Rauschens neben dem eigentlichen Signal zusätzlich ein Referenzsignal ausgelesen wird. Das Lesen der Signalwerte einer Zeile dauert dann beispielsweise 5 µs. Damit benötigt das Lesen eines Bildes mit beispielsweise 2000 Zeilen insgesamt 10 ms, so dass die Bildrate auf 100 Bilder pro Sekunde beschränkt ist.

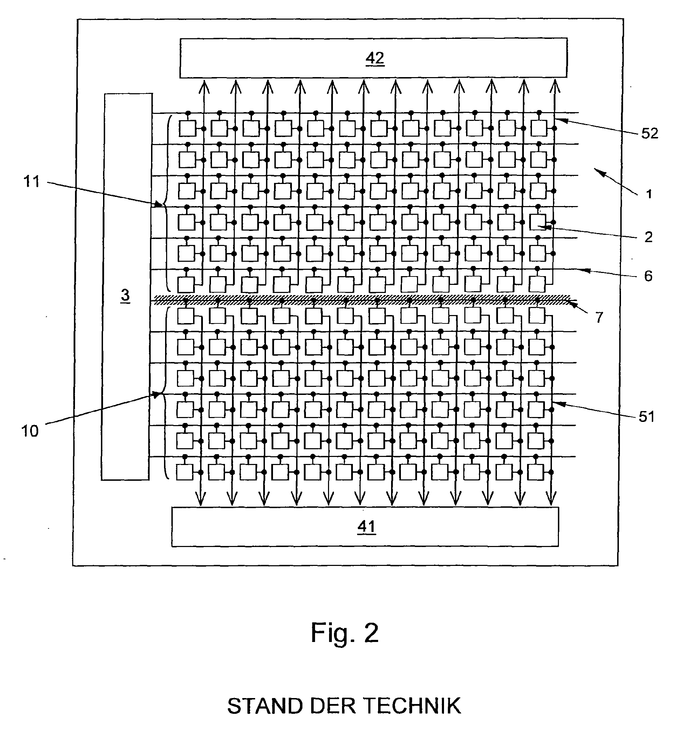

Um eine höhere Bildrate zu erreichen, ist es bekannt, die Spaltenleitungen in der Mitte zu teilen, wie es bei dem Bildsensor 1 gemäß Fig. 2 gezeigt ist.

Die Pixel 2 einer jeweiligen Spalte sind daher in eine erste, in Fig. 2 untere Pixelgruppe und eine zweite, in Fig. 2 obere Pixelgruppe unterteilt, wobei in jeder Spalte die Pixel 2 der jeweiligen ersten Pixelgruppe über eine gemeinsame erste Spaltenleitung 51 mit einem gemeinsamen ersten Spaltenverstärker 41 und die Pixel 2 der jeweiligen zweiten Pixelgruppe über eine gemeinsame zweite Spaltenleitung 52 mit einem gemeinsamen zweiten Spaltenverstärker 42 gekoppelt sind. Da die Spaltenleitungen 51, 52 des Bildsensors 1 gemäß Fig. 2 nur halb so lang sind, wie die Spaltenleitungen 5 des Bildsensors 1 gemäß Fig. 1, besitzen sie auch nur ca. die halbe Kapazität der Spaltenleitungen 5 des Bildsensors 1 gemäß Fig. 1. Zudem können jeweils zwei Zeilen, nämlich eine Zeile aus der unteren Bildfeldhälfte und eine Zeile aus der oberen Bildfeldhälfte, gleichzeitig ausgelesen werden. Die mögliche Bildrate kann dadurch auf beispielsweise 300 Bilder pro Sekunde ansteigen.

Die Signale der Pixel 2 des Bildsensors 1 gemäß Fig. 2 werden also über zwei Reihen von Spaltenverstärkern 41, 42, die in Fig. 2 am unteren und oberen Rand des Bildfelds angeordnet sind, ausgelesen. Hierdurch wird das auszulesende Bild und das Pixelfeld in zwei Blöcke 10, 11 derart aufgeteilt, dass die Pixel 2 des unteren Blocks 10 der unteren Reihe von Spaltenverstärkern 41 und die Pixel 2 des oberen Blocks 11 der oberen Reihe von Spaltenverstärkern 42 zugeordnet sind. Die Trennung der beiden Blöcke 10, 11 ist durch eine Trennlinie 7 veranschaulicht.

In der Regel können die einzelnen Spaltenverstärker nicht völlig identisch zueinander hergestellt werden. Vielmehr weichen die Spaltenverstärker in ihren Eigenschaften geringfügig voneinander ab. Beispielsweise kann eine Offsetspannung, eine Verstärkung oder eine Drift für unterschiedliche Spaltenverstärker geringfügig verschieden sein. Die dem jeweils abweichenden Spaltenverstärker zugeordneten Bildpunkte erscheinen dann im Vergleich zu den übrigen Bildpunkten etwas heller oder dunkler. Diese geringfügigen Abweichungen werden in der Regel mit dem Auge jedoch nicht wahrgenommen, wenn derartige geringfügige Abweichungen statistisch oder zufällig über das ganze Bild verteilt auftreten.

Sofern jedoch der Mittelwert der Abweichung über die obere Spaltenverstärkerreihe von dem Mittelwert der Abweichung über die untere Spaltenverstärkerreihe systematisch abweicht, beispielsweise aufgrund einer Abweichung eines oder mehrerer Prozessparameter bei der Herstellung der Spaltenverstärker, kann die zwischen den beiden Blöcken ausgebildete Grenze als eine in Fig. 2 waagrechte, durch die Bildmitte laufende Störung wahrgenommen werden, insbesondere deshalb, da das menschliche Auge linienförmige Strukturen verstärkt.

Der Erfindung liegt die Aufgabe zugrunde, einen Bildsensor der eingangs genannten Art mit geteilten Spaltenleitungen anzugeben, der ermöglicht, die Sichtbarkeit der Grenze zwischen derartigen Blöcken zu unterdrücken oder zumindest zu reduzieren.

Die Aufgabe wird durch einen Bildsensor mit den Merkmalen des Anspruchs 1 gelöst, und insbesondere dadurch, dass die Unterteilung der Pixel in die erste Pixelgruppe und die zweite Pixelgruppe für verschiedene Spalten unterschiedlich ist.

Bei dem erfindungsgemäßen Bildsensor verläuft die Grenze zwischen den Pixeln der ersten Pixelgruppe und den Pixeln der zweiten Pixelgruppe bezüglich verschiedener Spalten entlang unterschiedlicher Zeilen. Mit anderen Worten variieren die Anzahl der Pixel in der ersten Pixelgruppe und die Anzahl der Pixel in der zweiten Pixelgruppe zwischen den Spalten.

Die sich insbesondere über die gesamte Breite des Bildfelds erstreckende Grenze zwischen den Pixeln der ersten Pixelgruppen der Spalten und den Pixeln der zweiten Pixelgruppen der Spalten ist daher nicht mehr als gerade Linie ausgebildet, die mit dem Auge besonders gut wahrnehmbar ist. Hierdurch kann die Sichtbarkeit der vorgenannten Störung unterdrückt, zumindest jedoch reduziert werden.

Um einen Farbbildsensor zu erhalten, ist es üblich, die Pixel mit Farbfiltern zu versehen, die beispielsweise gemäß dem bekannten Bayer-Muster angeordnet sind. Bei dem Bayer-Muster sind die Farbfilter in ungeraden Zeilen in der Folge Rot-Grün und in geraden Zeilen in der Folge Grün-Blau angeordnet. Grundsätzlich können jedoch auch andere Farbfiltermasken als ein Bayer-Muster verwendet werden. Insbesondere für Farbbildsensoren ist es von Vorteil, wenn die Spalten in Gruppen von mehreren benachbarten Spalten unterteilt sind, wobei die Unterteilung der Pixel in die erste Pixelgruppe und die zweite Pixelgruppe innerhalb einer jeweiligen Spaltengruppe identisch ist. Hierdurch können Fehler bei der Farbinterpolation vermieden werden. Im Falle des genannten Bayer-Musters sind die Spalten vorzugsweise in Gruppen von genau zwei benachbarten Spalten unterteilt.

Die Unterteilung der Pixel in die erste Pixelgruppe und die zweite Pixelgruppe kann zwischen den Spalten oder zwischen den vorgenannten Gruppen von benachbarten Spalten alternieren. Mit anderen Worten variiert die zwischen den Pixeln der ersten Pixelgruppe und den Pixeln der zweiten Gruppe verlaufende Grenze abwechselnd zwischen genau zwei verschiedenen Verläufen. Die Unterteilung bei jeweils übernächst benachbarten Spalten oder Spaltengruppen ist dann identisch. Letztlich entstehen also ein erstes Unterteilungsmuster und ein zweites Unterteilungsmuster, die sich gegenseitig abwechseln.

Alternativ kann die Unterteilung der Pixel in die erste Pixelgruppe und die zweite Pixelgruppe zwischen den Spalten oder zwischen den vorgenannten Gruppen von benachbarten Spalten quasi-zufällig variieren. Unter dem Begriff "quasi-zufällige Variation" ist zu verstehen, dass die Variation der Unterteilung keine regelmäßige und/oder sich wiederholende Struktur aufweist. Hierdurch kann die Sichtbarkeit der Grenze zwischen den Blöcken weiter reduziert werden.

Diejenigen Zeilen, die wenigstens ein Pixel aus einer der ersten Pixelgruppen und wenigstens ein Pixel aus einer der zweiten Pixelgruppen umfassen, können einen Überlappungsbereich des Bildsensors bilden. Insbesondere ist der Überlappungsbereich bezüglich der Spaltenrichtung in einem mittleren Bereich des Bildsensors angeordnet.

Bevorzugt ist der Bildsensor dazu ausgebildet, diejenigen Zeilen, die außerhalb des Überlappungsbereichs angeordnet sind und lediglich Pixel der ersten Pixelgruppen umfassen, und diejenigen Zeilen, die außerhalb des Überlappungsbereichs angeordnet sind und lediglich Pixel der zweiten Pixelgruppen umfassen, parallel - d.h. paarweise gleichzeitig - auszulesen. Dies ist insbesondere deshalb möglich, da für die parallel auszulesenden Zeilen zwei voneinander getrennte Spaltenverstärkerreihen vorgesehen sind. Hierdurch kann die Bildrate erhöht werden.

Diejenigen Zeilen, die innerhalb des Überlappungsbereichs angeordnet sind, werden bevorzugt sequentiell - d.h. nacheinander - ausgelesen, insbesondere um zu vermeiden, dass mehrere, insbesondere genau zwei Pixel aus derselben Pixelgruppe einer Spalte gleichzeitig auf den gemeinsamen Spaltenverstärker geschaltet werden.

Eine vorteilhafte Weiterbildung der Erfindung betrifft das Problem, dass der vorgenannte Überlappungsbereich aus abwechselnd hellen und dunklen Streifen bestehen kann. Dies kann der Fall sein, wenn zwischen der ersten Spaltenverstärkerreihe und der zweiten Spaltenverstärkerreihe ein systematischer Fehler vorliegt, wie er vorstehend auch im Zusammenhang mit dem Nachteil des bekannten Bildsensors gemäß Fig. 2 erläutert ist. Wenn ein solcher Fehler die Höhe des verstärkten Signals und damit die Helligkeit eines Bildpunkts betrifft, so erscheinen die Pixel der ersten Pixelgruppen der Spalten im Bild entweder heller oder dunkler als die Pixel der zweiten Pixelgruppen der Spalten, wodurch in dem genannten Überlappungsbereich ein Streifenmuster entsteht. Ein derartiges Streifenmuster hat in der Regel eine sehr Ortsfrequenz, so dass das Streifenmuster mit dem Auge nicht unbedingt wahrgenommen werden kann.

Um das Auftreten eines derartigen Streifenmusters schon von vorneherein auszuschließen, ist der Bildsensor gemäß einer Weiterbildung dazu ausgebildet, die verstärkten Signale von Pixeln der ersten Pixelgruppen, die innerhalb des Überlappungsbereichs angeordnet sind, mit den verstärkten Signalen von Pixeln der zweiten Pixelgruppen, die innerhalb des Überlappungsbereichs angeordnet sind, zu verrechnen, und umgekehrt, um eine gegenseitige Helligkeitskompensation durchzuführen. Mit anderen Worten können die verstärkten Signale von solchen Pixeln der ersten Pixelgruppen, die innerhalb des Überlappungsbereichs angeordnet sind, in Abhängigkeit der verstärkten Signale von solchen Pixeln der zweiten Pixelgruppen, die ebenfalls innerhalb des Überlappungsbereichs angeordnet sind, modifiziert werden, wobei - umgekehrt - auch die verstärkten Signale von solchen Pixeln der zweiten Pixelgruppen, die innerhalb des Überlappungsbereichs angeordnet sind, in Abhängigkeit der verstärkten Signale von solchen Pixeln der ersten Pixelgruppen, die innerhalb des Überlappungsbereichs angeordnet sind, modifiziert werden.

Beispielsweise können der Mittelwert der verstärkten Signale der Pixel der ersten Pixelgruppen aus dem Überlappungsbereich und der Mittelwert der verstärkten Signale der Pixel der zweiten Pixelgruppen aus dem Überlappungsbereich berechnet und die halbe Differenz dieser beiden Mittelwerte auf die Signale der Pixel der "dunkleren" (d.h. ersten oder zweiten) Pixelgruppen aufaddiert bzw. von den Signalen der Pixel der "helleren" (d.h. zweiten bzw. ersten) Pixelgruppen subtrahiert werden. Der Überlappungsbereich erscheint somit in einer mittleren Helligkeit. Am oberen und unteren Rand des Überlappungsbereichs entsteht also jeweils ein Sprung, der der halben Differenz der Mittelwerte entspricht. Diese beiden Sprünge sind jedoch häufig so klein, dass sie mit dem Auge nicht mehr wahrgenommen werden können. Um diese Helligkeitssprünge noch weiter zu reduzieren, kann auch vorgesehen sein, dass die Helligkeitskompensation innerhalb des Überlappungsbereichs zu den Rändern des Überlappungsbereichs hin variiert.

Bevorzugt werden nicht nur die verstärkten Signale der innerhalb des Überlappungsbereichs angeordneten Pixel hinsichtlich ihrer Helligkeit kompensiert, sondern zusätzlich auch die verstärkten Signale der Pixel derjenigen außerhalb des Überlappungsbereichs angeordneten Zeilen, die sich in einem jeweiligen Grenzbereich zu den beiden Rändern des Überlappungsbereichs befinden. Mit anderen Worten wird auch bezüglich der verstärkten Signale der Pixel von einer oder mehreren an den Überlappungsbereich angrenzenden Zeilen eine Helligkeitskompensation durchgeführt. Der Bereich, in dem die Helligkeitskompensation durchgeführt wird, wird hierdurch vergrößert (bezogen auf den erläuterten Überlappungsbereich). Dabei ist weiterhin bevorzugt, wenn die Helligkeitskompensation mit steigendem Abstand von den Rändern reduziert wird. Hierdurch kann der jeweilige Helligkeitssprung in einen fließenden Helligkeitsübergang überführt werden. In einem Ausnahmefall kann sich der genannte jeweilige Grenzbereich über sämtliche Zeilen erstrecken, die außerhalb des Überlappungsbereichs angeordnet sind und lediglich Pixel der ersten Pixelgruppen oder lediglich Pixel der zweiten Pixelgruppen umfassen. Bei dieser Weiterbildung ist es möglich, dass als Grundlage für die Helligkeitskompensation der Signale von Pixeln außerhalb des Überlappungsbereichs lediglich die erläuterten Mittelwerte der verstärkten Signale der Pixel innerhalb Überlappungsbereichs berücksichtigt werden.

Vorteilhafte Ausführungsformen der Erfindung sind auch in den Unteransprüchen, der Beschreibung und der Zeichnung angegeben.

Die Erfindung wird im Folgenden beispielhaft unter Bezugnahme auf die Zeichnung beschrieben. Es zeigen, jeweils in schematischer Darstellung,
- Fig. 1: einen aus dem Stand der Technik bekannten Bildsensor mit durchgehenden Spaltenleitungen,
- Fig. 2: einen aus dem Stand der Technik bekannten Bildsensor mit in der Mitte geteilten Spaltenleitungen,
- Fig. 3: einen erfindungsgemäßen Bildsensor gemäß einer ersten Ausführungsform, und
- Fig. 4: einen erfindungsgemäßen Bildsensor gemäß einer zweiten Ausführungsform.

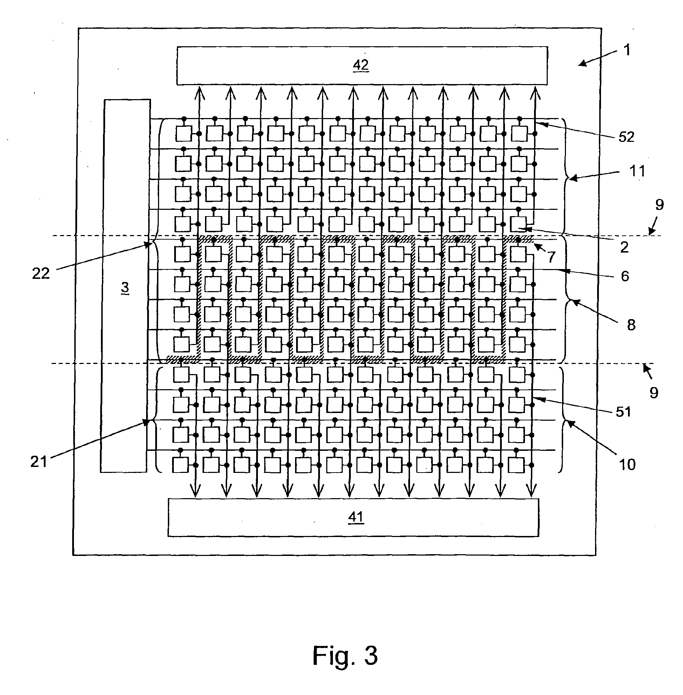

Der in Fig. 3 dargestellte CMOS-Bildsensor 1 weist eine Vielzahl von lichtempfindlichen Pixeln 2 auf, die in Zeilen (hier horizontal dargestellt) und Spalten (hier vertikal dargestellt) angeordnet sind. Jede Zeile besitzt eine Zeilenauswahlleitung 6 für die der jeweiligen Zeile zugeordneten Pixel 2. Der Bildsensor 1 umfasst ferner eine Zeilen-Adressierlogik 3, durch die jeweils eine der Zeilen 6 zum Auslesen der Signale der Pixel 2 dieser Zeile 6 ausgewählt werden kann.

Die Pixel einer jeden Spalte sind dabei in eine untere Pixelgruppe 21 und eine obere Pixelgruppe 22 unterteilt, wobei der Übersichtlichkeit halber in Fig. 3 die Unterteilung lediglich anhand der am linken Rand des Pixelfelds befindlichen Spalte mit Bezugszeichen veranschaulicht ist. Die untere Pixelgruppe 21 dieser herausgegriffenen Spalte umfasst vier Pixel 2, die obere Pixelgruppe 22 dieser Spalte umfasst acht Pixel 2. Das oberste Pixel 2 der jeweiligen unteren Pixelgruppe 21 und das unterste Pixel 2 der jeweiligen oberen Pixelgruppe 22 grenzen aneinander.

Die Pixel 2 der ersten Pixelgruppe 21 einer jeden Spalte sind über eine gemeinsame untere Spaltenleitung 51 mit einem gemeinsamen unteren Spaltenverstärker 41 gekoppelt, und die Pixel 2 der oberen Pixelgruppe 22 einer jeden Spalte sind über eine gemeinsame obere Spaltenleitung 52 mit einem gemeinsamen oberen Spaltenverstärker 42 gekoppelt. Die entlang einer Reihe angeordneten unteren Spaltenverstärker 41 sind der Einfachheit halber in Fig. 3 jedoch nicht einzeln dargestellt, sondern schematisiert als Spaltenverstärkerreihe 41. Entsprechendes gilt für die oberen Spaltenverstärker 42.

Die Unterteilung der Pixel 2 in die erste Pixelgruppe 21 und die zweite Pixelgruppe 22 alterniert zwischen den Spalten, d.h. die Unterteilung ist bei jeweils übernächst benachbarten Spalten identisch. Hierdurch wird ein Überlappungsbereich 8 geschaffen, der diejenigen Zeilen enthält, welche Pixel 2 sowohl aus den unteren Pixelgruppen 21 als auch Pixel 2 aus den oberen Pixelgruppen 22 umfassen. Bezüglich der hier vertikal dargestellten Spaltenrichtung ist der Überlappungsbereich 8 in einem mittleren Bereich des Bildsensors 1 angeordnet, und zwar zwischen denjenigen unteren Zeilen, die lediglich Pixel 2 der unteren Pixelgruppen 21 umfassen und einen unteren Block 10 definieren, und denjenigen oberen Zeilen, die lediglich Pixel 2 der oberen Pixelgruppen 22 umfassen und einen oberen Block 11 definieren. Im Überlappungsbereich 8 greifen die unteren Pixelgruppen 21 und die oberen Pixelgruppen 22 fingerartig ineinander.

Letztlich wird durch die alternierende Unterteilung der Pixel 2 eine Zickzack-Trennlinie 7 zwischen denjenigen Pixeln, die den unteren Pixelgruppen 21 zugeordnet sind, und denjenigen Pixeln, die den oberen Pixelgruppen 22 zugeordnet sind, geschaffen. Eine gerade, waagrechte Trennlinie zwischen einem unteren Pixelblock und einem oberen Pixelblock, wie sie von dem Bildsensor gemäß Fig. 2 bekannt ist und die eine durch die Bildmitte laufenden Störung verursachen kann, wird vermieden. Zwar besitzt der Überlappungsbereich 8 zu den außerhalb des Überlappungsbereichs 8 angeordneten Pixelzeilen 10, 11 einen ersten und zweiten Rand 9. Allerdings sind diese Ränder 9 am unteren und oberen Ende des Überlappungsbereichs 8 an jeder zweiten Spalte von einer unteren Pixelgruppe 21 bzw. einer oberen Pixelgruppe 22 unterbrochen, d.h. die Trennlinie 7 fällt nur an jeder zweiten Spalte mit einem jeweiligen Rand 9 des Überlappungsbereichs 8 zusammen. Diese alternierende Unterbrechung reduziert die Wahrnehmbarkeit der Ränder 9 des Überlappungsbereichs 8.

In Fig. 3 besitzen die beiden genannten Ränder 9 einen Abstand von vier Pixeln voneinander. Dieser Abstand ist lediglich beispielhaft und speziell für das in Fig. 3 dargestellte 12 x 12-Pixelfeld gewählt. CMOS-Bildsensoren für elektronische Kameras, insbesondere digitale Kinokameras, besitzen üblicherweise eine weitaus höhere Anzahl an Pixeln 2. Bei einem Bildsensor mit beispielsweise 2000 Zeilen könnte der vorgenannte Abstand beispielsweise 20 bis 30 Pixel betragen.

Die Zeilen des Überlappungsbereichs 8 werden sequentiell - d.h. nacheinander - ausgelesen. Die Zeilen des unteren Blocks 10 und die Zeilen des oberen Blocks 11 hingegen können parallel - d.h. paarweise gleichzeitig - ausgelesen werden. Bei einem Bildsensor mit beispielsweise insgesamt 2000 Zeilen und davon 20 Überlappungsbereichszeilen werden die genannten 20 Zeilen sequentiell ausgelesen, die restlichen 1980 Zeilen des unteren und oberen Blocks hingegen werden parallel ausgelesen. Gegenüber dem Bildsensor 1 gemäß Fig. 2 erhöht sich der Zeitbedarf für das Auslesen daher lediglich geringfügig von 1000 Zeilen auf 1010 Zeilen (990 + 20 Zeilen).

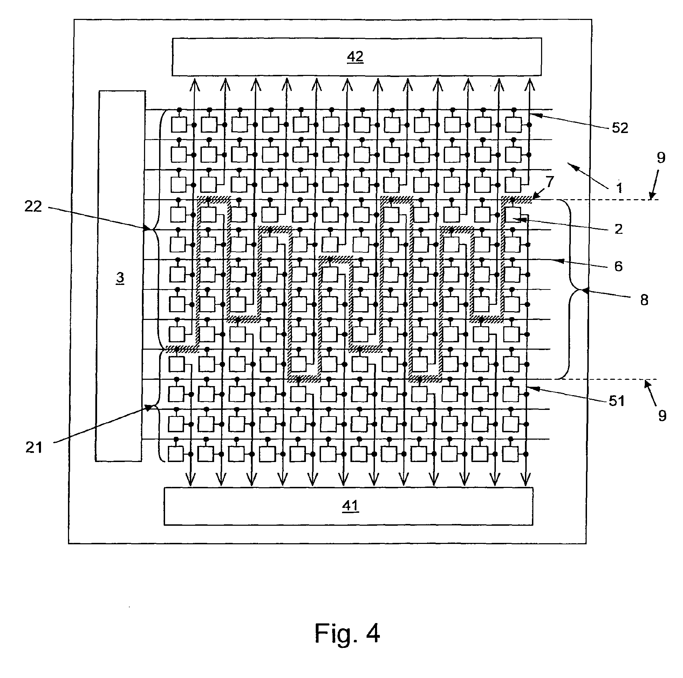

Die Wahrnehmbarkeit des unteren und oberen Endes des Überlappungsbereichs 8 - d.h. der Ränder 9 - kann noch weiter reduziert werden, wenn die Trennlinie 7 zwischen den unteren Pixelgruppen 21 und den oberen Pixelgruppen 22 nicht genau entlang zweier gerader Linien verläuft, sondern der Übergang zwischen der unteren Pixelgruppe 21 und der oberen Pixelgruppe 22 für unterschiedliche Spalten quasi-zufällig von solchen geraden Linien abweicht, wie dies bei dem Bildsensor gemäß Fig. 4 beispielhaft gezeigt ist.

Um das Auftreten eines Streifenmusters aufgrund eines Fehlers zwischen den Spaltenverstärkern 41 und den Spaltenverstärkern 42 auszuschließen, kann der der Bildsensor 1 gemäß Fig. 3 oder Fig. 4 dazu ausgebildet sein, die verstärkten Signale derjenigen Pixel 2 der ersten Pixelgruppen 21, die innerhalb des Überlappungsbereichs 8 angeordnet sind, mit den verstärkten Signalen derjenigen Pixel 2 der zweiten Pixelgruppen 22, die innerhalb des Überlappungsbereichs 8 angeordnet sind, zu verrechnen, und umgekehrt, um eine gegenseitige Helligkeitskompensation durchzuführen.

Lediglich der Anschaulichkeit halber ist in den Fig. 1 bis 4 ein 12 x 12 Pixelfeld gezeigt. Grundsätzlich wird die Anzahl der Zeilen und Spalten eines in der Praxis eingesetzten Bildsensors erheblich höher sein. Beispielsweise können die Bildsensoren eine Auflösung von 3018 x 2200 Pixeln besitzen.

Die Erfindung ermöglicht, die Wahrnehmbarkeit einer waagrecht, durch die Bildmitte laufenden Störung zumindest zu reduzieren.

### Bezugszeichenliste

- 1: Bildsensor
- 2: Pixel
- 3: Zeilen-Adressierlogik
- 4: Spaltenverstärker
- 5: Spaltenleitung
- 6: Zeilenauswahlleitung
- 7: Trennlinie
- 8: Überlappungsbereich
- 9: Rand des Überlappungsbereichs
- 10: unterer Block
- 11: oberer Block
- 21: untere Pixelgruppe
- 22: obere Pixelgruppe
- 41: unterer Spaltenverstärker
- 42: oberer Spaltenverstärker
- 51: untere Spaltenleitung
- 52: obere Spaltenleitung

## Patentansprüche

1. Bildsensor, insbesondere CMOS-Bildsensor, für elektronische Kameras, mit einer Vielzahl von in Zeilen und Spalten angeordneten lichtempfindlichen Pixeln (2), wobei die Pixel (2) einer jeweiligen Spalte in eine erste Pixelgruppe (21) und eine zweite Pixelgruppe (22) unterteilt sind, und wobei in jeder Spalte die Pixel (2) der jeweiligen ersten Pixelgruppe (21) über eine gemeinsame erste Spaltenleitung (51) mit einem gemeinsamen ersten Spaltenverstärker (41) und die Pixel der jeweiligen zweiten Pixelgruppe (22) über eine gemeinsame zweite Spaltenleitung (52) mit einem gemeinsamen zweiten Spaltenverstärker (42) gekoppelt sind,
**dadurch gekennzeichnet,**
**dass** die Unterteilung der Pixel (2) in die erste Pixelgruppe (21) und die zweite Pixelgruppe (22) für verschiedene Spalten unterschiedlich ist.

2. Bildsensor nach Anspruch 1,
wobei die Spalten in Gruppen von mehreren - insbesondere genau zwei - benachbarten Spalten unterteilt sind, wobei die Unterteilung der Pixel (2) in die erste Pixelgruppe (21) und die zweite Pixelgruppe (22) innerhalb einer jeweiligen Spaltengruppe identisch ist.

3. Bildsensor nach Anspruch 1 oder 2,
wobei die Unterteilung der Pixel (2) in die erste Pixelgruppe (21) und die zweite Pixelgruppe (22) zwischen den Spalten oder zwischen Gruppen von benachbarten Spalten alterniert.

4. Bildsensor nach Anspruch 1 oder 2,
wobei die Unterteilung der Pixel (2) in die erste Pixelgruppe (21) und die zweite Pixelgruppe (22) zwischen den Spalten oder zwischen Gruppen von benachbarten Spalten quasi-zufällig variiert.

5. Bildsensor nach zumindest einem der vorstehenden Ansprüche,
wobei diejenigen Zeilen, die wenigstens ein Pixel (2) aus einer der ersten Pixelgruppen (21) und wenigstens ein Pixel (2) aus einer der zweiten Pixelgruppen (22) umfassen, einen Überlappungsbereich (8) des Bildsensors (1) bilden.

6. Bildsensor nach Anspruch 5,
wobei der Überlappungsbereich (8) bezüglich der Spaltenrichtung in einem mittleren Bereich des Bildsensors (1) angeordnet ist.

7. Bildsensor nach Anspruch 5 oder 6,
wobei der Bildsensor (1) dazu ausgebildet ist, diejenigen Zeilen (10), die außerhalb des Überlappungsbereichs (8) angeordnet sind und lediglich Pixel (2) der ersten Pixelgruppen (21) umfassen, und diejenigen Zeilen (11), die außerhalb des Überlappungsbereichs (8) angeordnet sind und lediglich Pixel (2) der zweiten Pixelgruppen (22) umfassen, parallel auszulesen.

8. Bildsensor nach zumindest einem der Ansprüche 5 bis 7,
**dadurch gekennzeichnet**,
wobei der Bildsensor (1) dazu ausgebildet ist, diejenigen Zeilen, die innerhalb des Überlappungsbereichs (8) angeordnet sind, sequentiell auszulesen.

9. Bildsensor nach zumindest einem der Ansprüche 5 bis 8,
wobei der Bildsensor (1) dazu ausgebildet ist, die verstärkten Signale von solchen Pixeln (2) der ersten Pixelgruppen (21), die innerhalb des Überlappungsbereichs (8) angeordnet sind, mit den verstärkten Signalen von solchen Pixeln (2) der zweiten Pixelgruppen (22), die innerhalb des Überlappungsbereichs (8) angeordnet sind, zu verrechnen, und umgekehrt, um eine gegenseitige Helligkeitskompensation durchzuführen.

10. Bildsensor nach Anspruch 9,
wobei der Überlappungsbereich (8) zu den außerhalb des Überlappungsbereichs (8) angeordneten Zeilen (10, 11) einen ersten und zweiten Rand (9) aufweist, und wobei der Bildsensor (1) dazu ausgebildet ist, auch die verstärkten Signale der Pixel (2) derjenigen außerhalb des Überlappungsbereichs (8) angeordneten Zeilen (10, 11) hinsichtlich ihrer Helligkeit zu kompensieren, die sich in einem jeweiligen Grenzbereich zu den Rändern (9) befinden.

11. Bildsensor nach Anspruch 10,
wobei der Bildsensor (1) dazu ausgebildet ist, die Helligkeitskompensation mit steigendem Abstand von den Rändern (9) zu reduzieren.
